# EUROPEAN PATENT APPLICATION

(11) **EP 4 650 803 A1**
(43) Date of publication of application: **19.11.2025**
(21) Application number: 24815651.5
(22) Date of filing: 16.01.2024
(51) Int. Cl.: G01R 31/392, G01R 31/396, G01R 31/382, G01R 31/385, G01R 31/52, G01R 19/165, G01R 19/12, H02J 7/00, H01M 10/0525

(54) **BATTERY DIAGNOSIS DEVICE AND OPERATION METHOD THEREOF**

(30) Priority: 26.05.2023 KR 20230068552
(71) Applicant: LG Energy Solution, Ltd., Seoul 07335 (KR)
(72) Inventor: KANG, Ju Young, Daejeon 34122 (KR); PARK, Heung Il, Daejeon 34122 (KR); LEE, Da Jin, Daejeon 34122 (KR); CHO, In Hwan, Daejeon 34122 (KR); SEO, Jung Oh, Daejeon 34122 (KR)
(74) Representative: Goddar, Heinz J.
(86) International application number: PCT/KR2024/000763
(87) International publication number: WO 2024/248268

(57) **Abstract**

A battery diagnosis apparatus includes an information obtaining unit configured to measure a voltage and a current of a battery and a controller configured to calculate a charging capacity and a discharging capacity of the battery based on the voltage and the current and diagnose the battery based on a difference between the charging capacity and the discharging capacity, and a difference between a charging open circuit voltage (OCV) and a discharging OCV.

## Description

### [TECHNICAL FIELD]

### CROSS-REFERENCE TO RELATED APPLICATION

This application claims priority to and the benefit of Korean Patent Application No. 10-2023-0068552 filed in the Korean Intellectual Property Office on May 26, 2023, the entire content of which is incorporated herein by reference.

### TECHNICAL FIELD

Embodiments disclosed herein relate to a battery diagnosis apparatus and an operating method thereof.

### [BACKGROUND ART]

Current commercially available batteries include nickel cadmium batteries, nickel hydride batteries, nickel zinc batteries, lithium-ion batteries, and so forth, among which the lithium batteries are in the limelight due to their advantages of free charge and discharge due to little memory effect, very low self-discharge rate, and high energy density, compared to nickel-based batteries.

The lithium-ion battery is a secondary battery that includes a positive electrode, a negative electrode, an electrolyte, and a separator, and is chargeable and dischargeable according to movement of lithium ions between the positive electrode and the negative electrode through the electrolyte.

When such a battery ignites during the use thereof, a serious accident may occur due to reaction between chemical substances inside the battery. To prevent such an accident, a technique has been developed to diagnose the state of the battery by observing whether a voltage of the battery exceeds a preset voltage or a temperature of the battery exceeds a preset temperature. However, when the ignition of the battery is predicted based on the voltage and the temperature of the battery, the accuracy and reliability of the prediction are difficult to guarantee.

### [SUMMARY]

### [TECHNICAL PROBLEM]

Embodiments disclosed herein aim to provide a battery diagnosis apparatus and an operating method thereof in which short-circuit and lithium precipitation inside a battery and an ignition risk of the battery may be diagnosed in advance.

Technical problems of the embodiments disclosed herein are not limited to the above-described technical problems, and other unmentioned technical problems would be clearly understood by those skilled in the art in the technical field to which the present disclosure pertains from the following description.

### [TECHNICAL SOLUTION]

A battery diagnosis apparatus according to an embodiment disclosed herein includes an information obtaining unit configured to measure a voltage and a current of a battery and a controller configured to calculate a charging capacity and a discharging capacity of the battery based on the voltage and the current and diagnose the battery based on a difference between the charging capacity and the discharging capacity, and a difference between a charging open circuit voltage (OCV) and a discharging OCV.

According to an embodiment, the controller may be further configured to calculate the difference between the charging capacity and the discharging capacity and determine that the battery is abnormal when the difference between the charging capacity and the discharging capacity exceeds a first reference value.

According to an embodiment, the controller may be further configured to determine that the battery is in a risky state when the difference between the charging OCV and the discharging OCV is less than a second reference value.

According to an embodiment, the controller may be further configured to calculate a first difference, a second difference, and a third difference that are differences between the charging OCV and the discharging OCV corresponding to a first cycle, a second cycle, and a third cycle that are consecutive in sequence among a plurality of charging/discharging cycles of the battery, and determine that the state of the battery is the risky state when the second difference is less than the first difference and the third difference is less than the second difference.

According to an embodiment, the controller may be further configured to calculate a change rate of the discharging OCV and determine that the state of the battery is the risky state when the change rate of the discharging OCV falls beyond a preset range.

According to an embodiment, the controller may be further configured to calculate a change rate of the charging OCV and determine that the state of the battery is the risky state when the change rate of the charging OCV falls beyond a preset range.

According to an embodiment, the controller may be further configured to determine an occurrence of a short-circuit or a lithium precipitation inside the battery when the change rate of the charging OCV and the change rate of the discharging OCV fall within a preset range.

According to an embodiment, the controller may be further configured to determine that the state of the battery is a normal state when the difference between the charging capacity and the discharging capacity is less than or equal to a first reference value.

A battery diagnosis method according to an embodiment disclosed herein includes obtaining a charging capacity, a discharging capacity, a charging open circuit voltage (OCV), and a discharging OCV of a battery, calculating a difference between the charging capacity and the discharging capacity and a difference between the charging OCV and the discharging OCV, and determining a state of the battery based on the difference between the charging capacity and the discharging capacity and the difference between the charging OCV and the discharging OCV.

According to an embodiment, the determining the state of the battery may include determining that the state of the battery is a normal state when the difference between the charging capacity and the discharging capacity is less than or equal to a first reference value.

According to an embodiment, the determining the state of the battery may include determining whether the difference between the charging OCV and the discharging OCV is less than a second reference value when the difference between the charging capacity and the discharging capacity exceeds a first reference value.

According to an embodiment, the determining the state of the battery may include determining that the state of the battery is a risky state when the difference between the charging OCV and the discharging OCV is less than the second reference value.

According to an embodiment, the determining the state of the battery may include calculating a first difference, a second difference, and a third difference that are differences between the charging OCV and the discharging OCV corresponding to a first cycle, a second cycle, and a third cycle that are consecutive in a sequence among a plurality of charging/discharging cycles of the battery, and determining that a state of the battery is the risky state when the second difference is less than the first difference and the third difference is less than the second difference.

According to an embodiment, the determining the state of the battery includes determining an occurrence of a short-circuit or a lithium precipitation inside the battery when the difference between the charging OCV and the discharging OCV is greater than or equal to the second reference value.

Detailed matters of other embodiments are included in a detailed description and drawings.

### [ADVANTAGEOUS EFFECTS]

A battery diagnosis apparatus and an operating method thereof according to embodiments disclosed herein may diagnose a state of a battery based on a charging capacity, a discharging capacity, a charging OCV, and a discharging OCV, obtained based on a current and a voltage in charging and discharging of the battery.

The battery diagnosis apparatus and the operating method thereof according to embodiments disclosed herein may detect short-circuit or lithium precipitation inside the battery.

The battery diagnosis apparatus and the operating method thereof according to embodiments disclosed herein may diagnose an ignition risk situation of the battery in advance.

### [BRIEF DESCRIPTION OF THE DRAWINGS]

FIG. 1 is a block diagram of a battery pack according to an embodiment disclosed herein.
FIG. 2 is a block diagram of a battery diagnosis apparatus according to an embodiment disclosed herein.
FIG. 3 is a graph showing a state where a battery diagnosis apparatus according to an embodiment disclosed herein diagnoses short-circuit or lithium precipitation inside a battery.
FIG. 4 is a graph showing a state where a battery diagnosis apparatus according to an embodiment disclosed herein diagnoses an ignition risk situation of a battery.
FIG. 5 is a graph showing a state where a battery diagnosis apparatus according to an embodiment disclosed herein considers a charging OCV and a discharging OCV to diagnose an ignition risk situation of a battery.
FIG. 6 is a flowchart of a battery diagnosis method according to an embodiment disclosed herein.
FIG. 7 is a flowchart showing in detail an operation of determining a state of a battery in FIG. 6.
FIG. 8 illustrates a computing system that executes a battery diagnosis method, according to an embodiment disclosed herein.

### [DETAILED DESCRIPTION]

Hereinafter, embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present application.

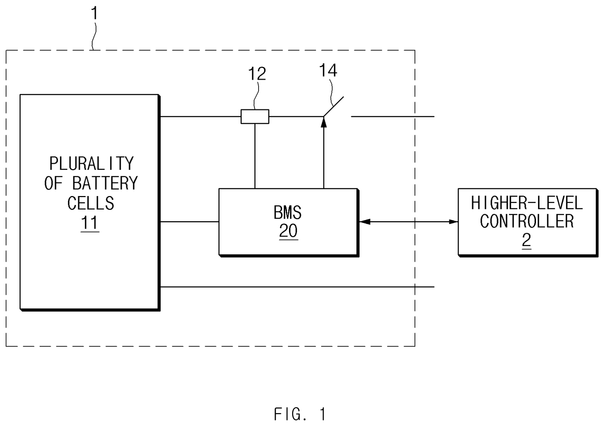

FIG. 1 is a block diagram of a battery pack according to an embodiment disclosed herein.

Referring to FIG. 1, a battery control system including a battery pack 1 and a higher-level controller 2 included in a higher-level system according to an embodiment disclosed herein is schematically shown.

As shown in FIG. 1, the battery pack 1 may include one or more battery cells 11, a switching unit 14 serially connected to a first terminal side and/or a second terminal side of the battery cell 11 to control a charging/discharging current flow of the battery cell 11, and a battery management system 20 for management to prevent over-charging and over-discharging by monitoring a voltage, a current, a temperature, etc., of the battery pack 1.

In this case, the battery pack 1 may include the battery cell 11, the sensor 12, the switching unit 14, and the battery management system 20 provided in plural. For example, the first terminal may be a positive (+) terminal of the battery cell 11, and the second terminal may be a negative (-) terminal.

Herein, as the switching unit 14 which is an element for controlling a current flow for charging or discharging of the plurality of battery cells 11, for example, at least one relay, magnetic contactor, etc., may be used according to specifications of the battery pack 1.

The battery management system 20, which is an interface for receiving measurement values of the above-described various parameter values, may include a plurality of terminals and a circuit, etc., connected thereto to process input values. The battery management system 20 may control on/off of the switching unit 14, e.g., a relay, a contactor, etc., and may be connected to the battery cell 11 to monitor the state of each battery cell 11.

The higher-level controller 2 may transmit a control signal regarding the battery cell 11 to the battery management system 20. Thus, the battery management system 20 may also be controlled in terms of an operation thereof based on a signal applied from the higher-level controller 2.

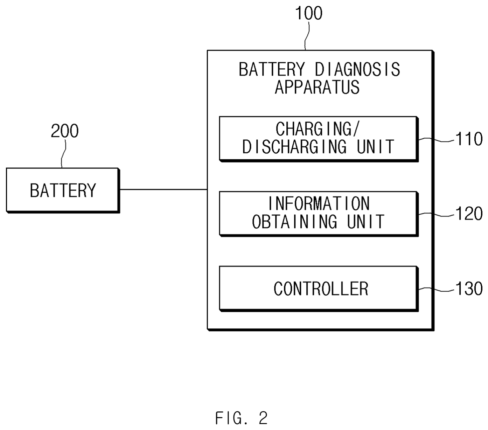

According to an embodiment, the battery management system 20 may include a battery diagnosis apparatus 100 of FIG. 2. According to another embodiment, the battery management system 20 may be different from the battery diagnosis apparatus 100 of FIG. 2. That is, the battery diagnosis apparatus 100 of FIG. 2 may be included in the battery pack 1 and may be configured as another device outside the battery pack 1. Hereinbelow, for convenience of description, it is assumed that the battery diagnosis apparatus 100 includes another device outside the battery pack 1, without being limited thereto. For example, the following operation of the battery diagnosis apparatus 100 may also be performed in various devices such as not only a battery management system (BMS) in a vehicle, but also a server, a cloud, a charger, a charger/discharger, etc.

FIG. 2 is a block diagram of a battery diagnosis apparatus according to an embodiment disclosed herein.

Referring to FIG. 2, the battery diagnosis apparatus 100 may include a charging/discharging unit 110, an information obtaining unit 120, and a controller 130. The battery diagnosis apparatus 100 may use the charging/discharging unit 110, an information obtaining unit 120, and a controller 130 to diagnose the state of the battery 200. According to an embodiment, the battery diagnosis apparatus 100 may be connected to a battery 200.

The charging/discharging unit 110 may charge/discharge the battery 200. The charging/discharging unit 110 may charge or discharge the battery 200 by supplying voltage or current to the battery 200.

The charging/discharging unit 110 may charge/discharge the battery 200 during a plurality of cycles. Thus, the battery diagnosis apparatus 100 may carry out a cycle test on the battery 200 by using the charging/discharging unit 110.

The information obtaining unit 120 may obtain information on the battery 200. According to an embodiment, the information obtaining unit 120 may obtain voltage information and current information of the battery 200. For example, the information obtaining unit 120 may obtain a voltage and a current corresponding to each of a plurality of charging/discharging cycles. In particular, the information obtaining unit 120 may respectively measure voltages at an end of charge and at an end of discharge included in each charging/discharging cycle. Herein, the voltage at the end of charge of the battery 200 may be defined as a charging open circuit voltage (OCV). In addition, the voltage at the end of discharge of the battery 200 may be defined as a discharging OCV.

The controller 130 may calculate a charging capacity of the battery 200. The controller 130 may calculate a charging capacity corresponding to each of the plurality of cycles. According to an embodiment, the controller 130 may calculate the charging capacity of the battery 200 based on current information and a charging time corresponding to each of the plurality of charging/discharging cycles of the battery 200.

The controller 130 may calculate a discharging capacity of the battery 200. The controller 130 may calculate a discharging capacity corresponding to each of the plurality of cycles. According to an embodiment, the controller 130 may calculate the discharging capacity of the battery 200 based on current information and a discharging time corresponding to each of the plurality of charging/discharging cycles of the battery 200.

The controller 130 may compare the charging capacity with the discharging capacity. The controller 130 may compare the charging capacity and the discharging capacity, obtained based on the same cycle among the plurality of charging/discharging cycles, with each other. According to an embodiment, the controller 130 may calculate a difference between the charging capacity and the discharging capacity to compare the charging capacity with the discharging capacity. Thus, the controller 130 may diagnose the state of the battery 200 based on the difference between the charging capacity and the discharging capacity, without being limited thereto. According to an embodiment, the controller 130 may calculate a ratio of the charging capacity to the discharging capacity to compare the charging capacity with the discharging capacity and diagnose the state of the battery 200 based on the ratio of the charging capacity to the discharging capacity.

The controller 130 may compare the charging OCV with the discharging OCV. The controller 130 may compare the charging OCV and the discharging OCV corresponding to each of the plurality of charging/discharging cycles, with each other. According to an embodiment, the controller 130 may calculate a difference between the charging OCV and the discharging OCV to compare the charging OCV with the discharging OCV. Thus, the controller 130 may obtain the difference between the charging OCV and the discharging OCV corresponding to each of the plurality of charging/discharging cycles.

The controller 130 may calculate a change amount of the charging OCV. The controller 130 may compare the charging OCV corresponding to each of the plurality of charging/discharging cycles to calculate the change amount of the charging OCV. For example, the controller 130 may compare a first charging OCV, a second charging OCV, and a third charging OCV respectively corresponding to a first cycle, a second cycle, and a third cycle that are consecutive in sequence to calculate a change amount of the charging OCV. The controller 130 may calculate the change amount of the charging OCV corresponding to the second cycle, based on a value obtained by subtracting the first charging OCV from the second charging OCV. The controller 130 may also calculate the change amount of the charging OCV corresponding to the third cycle, based on a value obtained by subtracting the second charging OCV from the third charging OCV.

The controller 130 may calculate a change amount of the discharging OCV. The controller 130 may compare the discharging OCV corresponding to each of the plurality of charging/discharging cycles to calculate the change amount of the discharging OCV. For example, the controller 130 may compare a first discharging OCV, a second discharging OCV, and a third discharging OCV respectively corresponding to a first cycle, a second cycle, and a third cycle that are consecutive in sequence to calculate a change amount of the discharging OCV. The controller 130 may calculate the change amount of the discharging OCV corresponding to the second cycle, based on a value obtained by subtracting the first discharging OCV from the second discharging OCV. The controller 130 may also calculate the change amount of the discharging OCV corresponding to the third cycle, based on a value obtained by subtracting the second discharging OCV from the third discharging OCV.

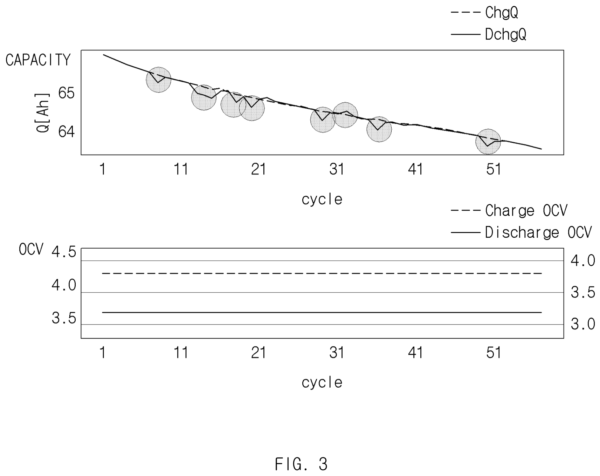

The controller 130 may determine the state of the battery 200. The controller 130 may determine the state of the battery 200 based on a charging capacity, a discharging capacity, a charging OCV, and a discharging OCV. In FIGS. 3 to 5, a detailed description will be made of an operation, performed by the controller 130, of determining the state of the battery 200.

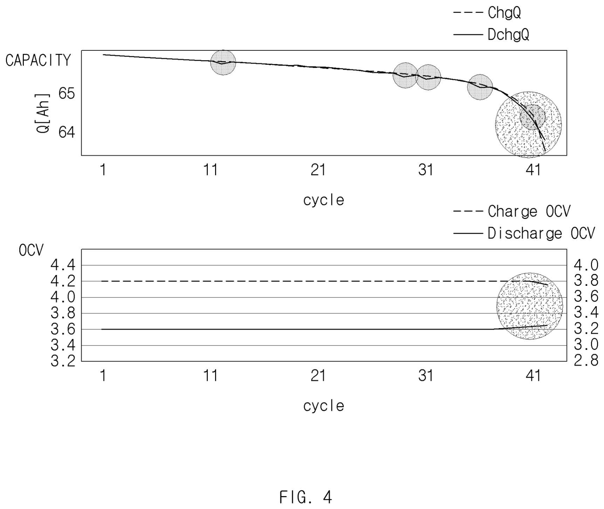

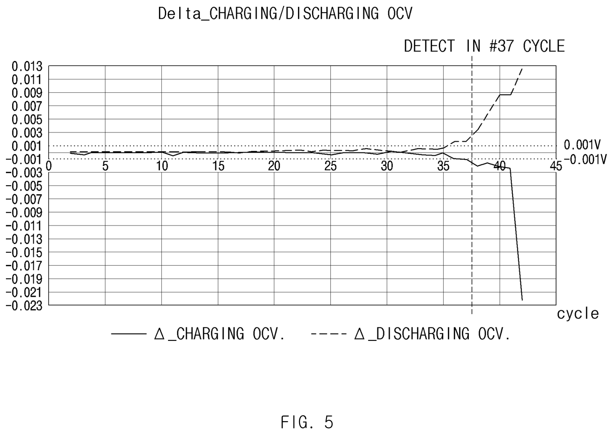

FIG. 3 is a graph showing a state where a battery diagnosis apparatus according to an embodiment disclosed herein diagnoses short-circuit or lithium precipitation inside a battery. FIG. 4 is a graph showing a state where a battery diagnosis apparatus according to an embodiment disclosed herein diagnoses an ignition risk situation of a battery. FIG. 5 is a graph showing a state where a battery diagnosis apparatus according to an embodiment disclosed herein considers a charging OCV and a discharging OCV to diagnose an ignition risk situation of a battery.

Referring to FIG. 3, the controller 130 may compare a charging capacity and a discharging capacity corresponding to each of the plurality of cycles, with each other. For example, the controller 130 may calculate a difference between the charging capacity and the discharging capacity corresponding to each of the plurality of cycles.

The controller 130 may compare the difference between the charging capacity and the discharging capacity with a first reference value. Herein, the first reference value may be a preset value for detecting a change of the discharging capacity with respect to the charging capacity.

The controller 130 may compare the difference between the charging capacity and the discharging capacity with the first reference value. In this way, the controller 130 may determine whether the difference between the charging capacity and the discharging capacity exceeds the first reference value.

According to an embodiment, the controller 130 may determine that the state of the battery 200 is abnormal, when there is a cycle for which the difference between the charging capacity and the discharging capacity exceeds the first reference value.

The controller 130 may determine that the state of the battery 200 is normal, when there is no cycle for which the difference between the charging capacity and the discharging capacity exceeds the first reference value. That is, the controller 130 may determine that the state of the battery 200 is normal, when the difference between the charging capacity and the discharging capacity for each of the plurality of charging/discharging cycles is less than or equal to the first reference value.

According to an embodiment, the controller 130 may calculate the number of times in which the difference between the charging capacity and the discharging capacity exceeds the first reference value among the plurality of cycles. In this case, the controller 130 may determine that the state of the battery 200 is abnormal, when the number of times the difference between the charging capacity and the discharging capacity exceeds the first reference value is a preset number of times or more. Herein, the preset number of times may be set based on a type, a total number of charging/discharging cycles of the battery 200, etc. In this case, the controller 130 may determine that the state of the battery 200 is normal, when the number of times the difference between the charging capacity and the discharging capacity exceeds the first reference value is less than the preset number of times.

The controller 130 may determine a detailed state of the battery 220 based on the charging OCV and the discharging OCV when determining that the state of the battery 200 is abnormal. According to an embodiment, the controller 130 may calculate the difference between the charging OCV and the discharging OCV corresponding to each of the plurality of charging/discharging cycles.

When the difference between the charging OCV and the discharging OCV is greater than or equal to a second reference value, the controller 130 may determine that short-circuit or lithium precipitation occurs inside the battery 200. That is, when the difference between the charging OCV and the discharging OCV corresponding to each of the plurality of cycles all is greater than or equal to the second reference value, the controller 130 may determine that short-circuit or lithium precipitation occurs inside the battery 200. Herein, the second reference value may be set based on a difference between the charging OCV and the discharging OCV corresponding to the initial cycle among the charging/discharging cycles, a type of the battery 200 or a charger/discharger, etc.

According to an embodiment, the controller 130 may determine that short-circuit or lithium precipitation occurs inside the battery 200 based on the detailed state of the battery 200 determined to be abnormal, when each of the charging OCV and the discharging OCV does not change in the plurality of charring/discharging cycles.

Referring to FIG. 4, the controller 130 may diagnose the ignition risk of the battery 200. The controller 130 may determine a detailed state of the battery 220 based on the charging OCV and the discharging OCV when determining that the state of the battery 200 is abnormal.

According to an embodiment, the controller 130 may determine that the state of the battery 200 is a risky state, when the difference between the charging capacity and the discharging capacity is less than the second reference value. Herein, the risky state may mean the ignition risk state of the battery 200. That is, the controller 130 may determine that the state of the battery 200 is a risky state, when the difference between the charging capacity and the discharging capacity is greater than or equal to the first reference value and the difference between the charging OCV and the discharging OCV is less than the second reference value.

According to an embodiment, the controller 130 may calculate a first difference, a second difference, and a third difference that are differences between the charging OCV and the discharging OCV corresponding to the first cycle, the second cycle, and the third cycle that are consecutive in sequence among the plurality of charging/discharging cycles of the battery 200. The controller 130 may compare the first difference, the second difference, and the third difference with one another. Thus, when the second difference is less than the first difference and the third difference is less than the second difference, the controller 130 may determine that the state of the battery 200 is the risky state. That is, when the charging OCV decreases and the discharging OCV increases, the controller 130 may determine that the state of the battery 200 is the risky state.

In the drawing, the controller 130 may determine that in the battery 200, a difference between the charging OCV and the discharging OCV for a 40^{th} cycle is less than a difference between the charging OCV and the discharging OCV for a 39^{th} cycle and a difference between the charging OCV and the discharging OCV for a 41^{st} cycle is less than the difference between the charging OCV and the discharging OCV for the 40^{th} cycle. Thus, the controller 130 may determine that the state of the battery 200 for which the charging/discharging cycle of the 41^{st} cycle has elapsed is the risky state.

Referring to FIG. 5, the controller 130 may calculate a change rate of the charging OCV and a change rate of the discharging OCV. The controller 130 may determine the state of the battery 200 based on a change of a charging OCV and a change of a discharging OCV.

The controller 130 may calculate the change rate of the charging OCV and the change rate of the discharging OCV corresponding to each of the plurality of charging/discharging cycles. For example, the controller 130 may calculate the change rate of the charging OCV based on a value obtained by subtracting a charging OCV for a previous cycle from a charging OCV for a corresponding cycle. The controller 130 may calculate the change rate of the discharging OCV based on a value obtained by subtracting a discharging OCV for the previous cycle from a discharging OCV for the corresponding cycle.

For the normal battery 200, the charging OCV and the discharging OCV are maintained constant within an error range, such that the change rate of the charging OCV and the change rate of the discharging OCV according to a charging/discharging cycle may be 0.

According to an embodiment, the controller 130 may determine whether the change rate of the charging OCV falls beyond a preset range. The controller 130 may also determine whether the change rate of the discharging OCV falls beyond the preset range. Herein, the preset range may be set based on a type of the battery 200, a type of a charger/discharger, an error range, etc.

According to an embodiment, the controller 130 may determine that the state of the battery 200 is the risky state, when the change rate of the charging OCV falls beyond the preset range. When the change rate of the charging OCV falls within the preset range, the controller 130 may determine that short-circuit or lithium precipitation occurs inside the battery 200.

According to an embodiment, the controller 130 may determine that the state of the battery 200 is the risky state, when the change rate of the discharging OCV falls beyond the preset range. When the change rate of the discharging OCV falls within the preset range, the controller 130 may determine that short-circuit or lithium precipitation occurs inside the battery 200.

According to an embodiment, the controller 130 may determine that the state of the battery 200 is the risky state, when both the change rate of the charging OCV and the change rate of the discharging OCV fall beyond the preset range. When at least one of the change rate of the charging OCV and the change rate of the discharging OCV falls within the preset range, the controller 130 may determine that short-circuit or lithium precipitation occurs inside the battery 200.

In the drawing, the controller 130 may determine that the change rate of the charging OCV and the change rate of the discharging OCV fall within the preset range from 0^{th} to 36^{th} cycles of the charging/discharging cycle and the change rate of the charging OCV and the change rate of the discharging OCV fall beyond the preset range for a 37^{th} cycle. Thus, the controller 130 may determine that the state of the battery 200 for the 37^{th} cycle among the plurality of charging/discharging cycles is the risky state.

In other words, the controller 130 may determine that the state of the battery 200 is the risky state when the charging OCV gradually decreases and the discharging OCV gradually increases over repetition of the charging/discharging cycle, and thus the change rate of the charging OCV has a value less than or equal to the preset range and the change rate of the discharging OCV has a value greater than or equal to the preset range.

When the battery 200 is determined to be abnormal as a result of diagnosis, the controller 130 may provide information on the abnormal battery 200 to a user. For example, the controller 130 may provide information on the abnormal battery 200 to the user terminal through a communication unit (not shown) and provide the information about the abnormal battery 200 through a display provided in a vehicle, a charger, etc.

The battery diagnosis apparatus 100 may diagnose the state of the battery 200 based on a charging capacity, a discharging capacity, a charging OCV, and a discharging OCV. Thus, the battery diagnosis apparatus 100 may improve the accuracy of diagnosis of the state of the battery 200.

The battery diagnosis apparatus 100 may primarily diagnose the state of the battery 200 based on the charging capacity and the discharging capacity, and secondarily diagnose the battery 200 determined to be in the abnormal state, based on the charging OCV and the discharging OCV. Consequently, the battery diagnosis apparatus 100 may identify the state of the battery 200 as one of a normal state, a short-circuit or lithium precipitation occurring state, and an ignition risk state. In this way, the battery diagnosis apparatus 100 may provide a detailed state of the battery 200 to the user who may efficiently respond to the abnormal battery 200.

Moreover, as the battery diagnosis apparatus 100 informs the user of a fire risk state of the battery 200 in advance through the diagnosis of the battery 200, the user may prevent the fire of the battery 200.

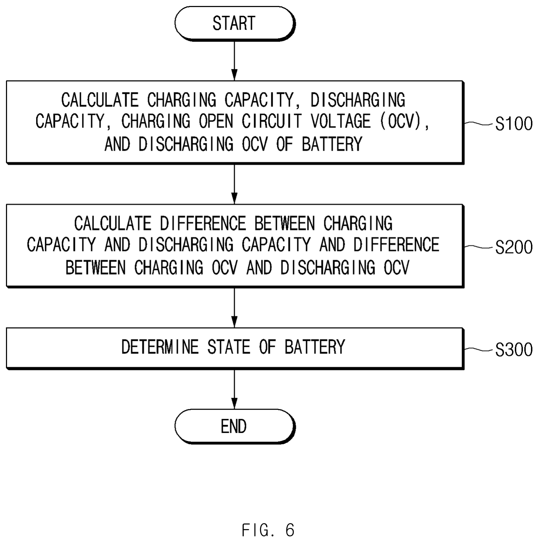

FIG. 6 is a flowchart of a battery 200 diagnosis method according to an embodiment disclosed herein.

The embodiment shown in FIG. 6 may be an example, and an order of operations according to various embodiments of the present disclosure may be different from that shown in FIG. 6, and some operations shown in FIG. 6 may be omitted, the order of the operations may be changed, or the operations may be merged.

Referring to FIG. 6, the battery 200 diagnosis method may include operation S100 of calculating a charging capacity, a discharging capacity, a charging OCV, and a discharging OCV of the battery 200, operation S200 of calculating a difference between the charging capacity and the discharging capacity and a difference between a charging OCV and a discharging OCV, and operation S300 of determining a state of the battery 200.

Hereinbelow, operations S100 through S300 will be described in detail with reference to FIGS. 1 to 5.

In operation S100, the battery diagnosis apparatus 100 may calculate the charging capacity, the discharging capacity, the charging OCV, and the discharging OCV of the battery 200.

The battery diagnosis apparatus 100 may obtain information on the battery 200. According to an embodiment, the battery diagnosis apparatus 100 may obtain voltage information and current information of the battery 200. For example, the battery diagnosis apparatus 100 may obtain a voltage and a current corresponding to each of a plurality of charging/discharging cycles. In particular, the battery diagnosis apparatus 100 may respectively measure voltages at an end of charge and at an end of discharge included in each charging/discharging cycle. Herein, the voltage at the end of charge of the battery 200 may be defined as an OCV. In addition, the voltage at the end of discharge of the battery 200 may be defined as a discharging OCV.

The battery diagnosis apparatus 100 may calculate a charging capacity of the battery 200. The battery diagnosis apparatus 100 may calculate a charging capacity corresponding to each of the plurality of cycles. According to an embodiment, the battery diagnosis apparatus 100 may calculate the charging capacity of the battery 200 based on current information and a charging time corresponding to each of the plurality of charging/discharging cycles of the battery 200.

The battery diagnosis apparatus 100 may calculate a discharging capacity of the battery 200. The battery diagnosis apparatus 100 may calculate a discharging capacity corresponding to each of the plurality of cycles. According to an embodiment, the battery diagnosis apparatus 100 may calculate the charging capacity of the battery 200 based on current information and a discharging time corresponding to each of the plurality of charging/discharging cycles of the battery 200.

In operation S200, the battery diagnosis apparatus 100 may calculate the difference between the charging capacity and the discharging capacity and the difference between the charging OCV and the discharging OCV.

The battery diagnosis apparatus 100 may compare the charging capacity with the discharging capacity. The battery diagnosis apparatus 100 may compare the charging capacity and the discharging capacity, obtained based on the same cycle among the plurality of charging/discharging cycles, with each other. According to an embodiment, the battery diagnosis apparatus 100 may calculate a difference between the charging capacity and the discharging capacity to compare the charging capacity with the discharging capacity. Thus, the battery diagnosis apparatus 100 may diagnose the state of the battery 200 based on the difference between the charging capacity and the discharging capacity, without being limited thereto. According to an embodiment, the battery diagnosis apparatus 100 may calculate a ratio of the charging capacity to the discharging capacity to compare the charging capacity with the discharging capacity and diagnose the state of the battery 200 based on the ratio of the charging capacity to the discharging capacity.

The battery diagnosis apparatus 100 may compare the charging OCV with the discharging OCV. The battery diagnosis apparatus 100 may compare the charging OCV and the discharging OCV corresponding to each of the plurality of charging/discharging cycles, with each other. According to an embodiment, the battery diagnosis apparatus 100 may calculate a difference between the charging OCV and the discharging OCV to compare the charging OCV with the discharging OCV. Thus, the battery diagnosis apparatus 100 may obtain the difference between the charging OCV and the discharging OCV corresponding to each of the plurality of charging/discharging cycles.

In operation S300, the battery diagnosis apparatus 100 may determine the state of the battery 200.

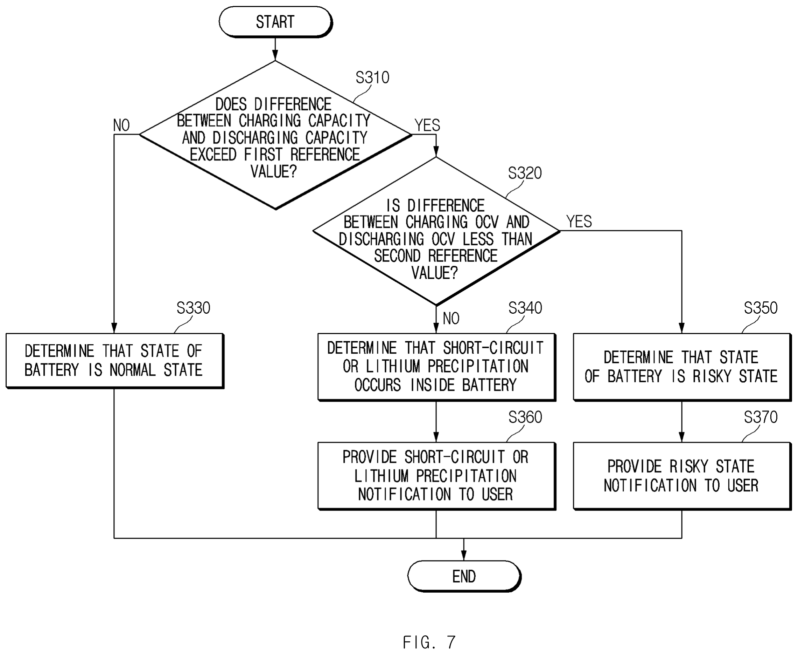

The battery diagnosis apparatus 100 may determine the state of the battery 200 based on a charging capacity, a discharging capacity, a charging OCV, and a discharging OCV. This will be described in detail with reference to FIG. 7.

FIG. 7 is a flowchart showing in detail an operation of determining the state of the battery 200 in FIG. 6.

In operation S310, the battery diagnosis apparatus 100 may determine whether the difference between the charging capacity and the discharging capacity exceeds the first reference value.

The battery diagnosis apparatus 100 may compare the difference between the charging capacity and the discharging capacity with a first reference value. Herein, the first reference value may be a preset value for detecting a change of the discharging capacity with respect to the charging capacity.

The battery diagnosis apparatus 100 may compare the difference between the charging capacity and the discharging capacity with the first reference value. In this way, the battery diagnosis apparatus 100 may determine whether the difference between the charging capacity and the discharging capacity exceeds the first reference value.

When the difference between the charging capacity and the discharging capacity exceeds the first reference value, the battery diagnosis apparatus 100 may perform operation S320. When the difference between the charging capacity and the discharging capacity is less than or equal to the first reference value, the battery diagnosis apparatus 100 may perform operation S330.

In operation S320, the battery diagnosis apparatus 100 may determine whether the difference between the charging OCV and the discharging OCV is less than the second reference value.

The battery diagnosis apparatus 100 may determine a detailed state of the battery 220 based on the charging OCV and the discharging OCV when determining that the state of the battery 200 is abnormal. According to an embodiment, the battery diagnosis apparatus 100 may calculate the difference between the charging OCV and the discharging OCV corresponding to each of the plurality of charging/discharging cycles.

The battery diagnosis apparatus 100 may compare the difference between the charging OCV and the discharging OCV with the second reference value. When the difference between the charging OCV and the discharging OCV is greater than or equal to the second reference value, the battery diagnosis apparatus 100 may perform operation S340. When the difference between the charging OCV and the discharging OCV is less than the second reference value, the battery diagnosis apparatus 100 may perform operation S350.

In operation S330, the battery diagnosis apparatus 100 may determine that the state of the battery 200 is the normal state. According to an embodiment, in this case, the battery diagnosis apparatus 100 may not provide a separate notification to the user, without being limited thereto. For example, the battery diagnosis apparatus 100 may provide a normal state notification of the battery 200 to the user.

In operation S340, the battery diagnosis apparatus 100 may determine that short-circuit or lithium precipitation occurs inside the battery 200. That is, when the difference between the charging capacity and the discharging capacity exceeds the first reference value and the difference between the charging OCV and the discharging OCV is greater than or equal to the second reference value, the battery diagnosis apparatus 100 may determine that short-circuit or lithium precipitation occurs inside the battery 200.

In operation S350, the battery diagnosis apparatus 100 may determine that the state of the battery 200 is the risky state. That is, when the difference between the charging capacity and the discharging capacity exceeds the first reference value and the difference between the charging OCV and the discharging OCV is less than the second reference value, the battery diagnosis apparatus 100 may determine that the state of the battery 200 is the risky state.

In operation S360, the battery diagnosis apparatus 100 may provide a short-circuit or lithium precipitation notification to the user.

In operation S370, the battery diagnosis apparatus 100 may provide a risk state notification to the user.

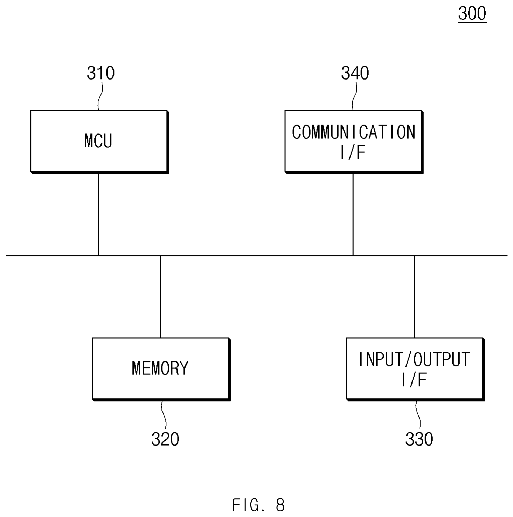

FIG. 8 illustrates a computing system that executes a battery diagnosis method, according to an embodiment disclosed herein.

Referring to FIG. 7, a computing system 300 according to an embodiment disclosed herein may include an MCU 310, a memory 320, an input/output I/F 330, and a communication I/F 340.

The MCU 310 may be a processor that executes various programs (e.g., an SOH calculation program, a cell balancing target determination program, etc.) stored in the memory 320, processes various data including an SOC, an SOH, etc., of the plurality of battery cells through these programs, and executes the above-described functions of the battery diagnosis apparatus 100 described with reference to FIGS. 1 to 7.

The memory 320 may store various programs regarding SOH calculation of the battery cell, cell balancing target determination, etc. Moreover, the memory 320 may store various data such as SOC data, SOH data, etc., of each battery cell.

The memory 320 may be provided in plural, depending on a need. The memory 320 may be volatile memory or non-volatile memory. For the memory 320 as the volatile memory, random access memory (RAM), dynamic RAM (DRAM), static RAM (SRAM), etc., may be used. For the memory 320 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 320 are merely examples and are not limited thereto.

The input/output I/F 330 may provide an interface for transmitting and receiving data by connecting an input device (not shown) such as a keyboard, a mouse, a touch panel, etc., and an output device such as a display (not shown), etc., to the MCU 310.

The communication I/F 340, which is a component capable of transmitting and receiving various data to and from a server, may be various devices capable of supporting wired or wireless communication. For example, a program for SOH calculation of the battery cell or balancing target determination or various data, etc., may be transmitted and received to and from a separately provided external server through the communication I/F 340.

As such, the battery management method according to an embodiment disclosed herein may be recorded in the memory 320 and executed by the MCU 310.

The above description is merely illustrative of the technical idea of the present disclosure, and various modifications and variations will be possible without departing from the essential characteristics of embodiments of the present disclosure by those of ordinary skill in the art to which the embodiments disclosed herein pertains.

Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of the present disclosure.

## Claims

1. A battery diagnosis apparatus comprising:
an information obtaining unit configured to measure a voltage and a current of a battery; and
a controller configured to calculate a charging capacity and a discharging capacity of the battery based on the voltage and the current and diagnose the battery based on a difference between the charging capacity and the discharging capacity, and a difference between a charging open circuit voltage (OCV) and a discharging OCV.

2. The battery diagnosis apparatus of claim 1, wherein the controller is further configured to:
calculate the difference between the charging capacity and the discharging capacity; and
determine that the battery is abnormal when the difference between the charging capacity and the discharging capacity exceeds a first reference value.

3. The battery diagnosis apparatus of claim 2, wherein the controller is further configured to determine that the battery is in a risky state when the difference between the charging OCV and the discharging OCV is less than a second reference value.

4. The battery diagnosis apparatus of claim 3, wherein the controller is further configured to:
calculate a first difference, a second difference, and a third difference that are differences between the charging OCV and the discharging OCV corresponding to a first cycle, a second cycle, and a third cycle that are consecutive in a sequence among a plurality of charging/discharging cycles of the battery; and
determine that the state of the battery is the risky state when the second difference is less than the first difference and the third difference is less than the second difference.

5. The battery diagnosis apparatus of claim 3, wherein the controller is further configured to:
calculate a change rate of the discharging OCV; and
determine that the state of the battery is the risky state when the change rate of the discharging OCV falls beyond a preset range.

6. The battery diagnosis apparatus of claim 3, wherein the controller is further configured to:
calculate a change rate of the charging OCV; and
determine that the state of the battery is the risky state when the change rate of the charging OCV falls beyond a preset range.

7. The battery diagnosis apparatus of claim 2, wherein the controller is further configured to determine an occurrence of a short-circuit or a lithium precipitation inside the battery when the change rate of the charging OCV and the change rate of the discharging OCV fall within a preset range.

8. The battery diagnosis apparatus of claim 1, wherein the controller is further configured to determine that the state of the battery is a normal state when the difference between the charging capacity and the discharging capacity is less than or equal to a first reference value.

9. A battery diagnosis method comprising:
obtaining a charging capacity, a discharging capacity, a charging open circuit voltage (OCV), and a discharging OCV of a battery;
calculating a difference between the charging capacity and the discharging capacity and a difference between the charging OCV and the discharging OCV; and
determining a state of the battery based on the difference between the charging capacity and the discharging capacity and the difference between the charging OCV and the discharging OCV.

10. The battery diagnosis method of claim 9, wherein the determining the state of the battery comprises determining that the state of the battery is a normal state when the difference between the charging capacity and the discharging capacity is less than or equal to a first reference value.

11. The battery diagnosis method of claim 9, wherein the determining the state of the battery comprises determining whether the difference between the charging OCV and the discharging OCV is less than a second reference value when the difference between the charging capacity and the discharging capacity exceeds a first reference value.

12. The battery diagnosis method of claim 11, wherein the determining the state of the battery comprises determining that the state of the battery is a risky state when the difference between the charging OCV and the discharging OCV is less than the second reference value.

13. The battery diagnosis method of claim 11, wherein the determining the state of the battery comprises:
calculating a first difference, a second difference, and a third difference that are differences between the charging OCV and the discharging OCV corresponding to a first cycle, a second cycle, and a third cycle that are consecutive in a sequence among a plurality of charging/discharging cycles of the battery; and
determining that a state of the battery is the risky state when the second difference is less than the first difference and the third difference is less than the second difference.

14. The battery diagnosis method of claim 11, wherein the determining the state of the battery comprises determining an occurrence of a short-circuit or a lithium precipitation inside the battery when the difference between the charging OCV and the discharging OCV is greater than or equal to the second reference value.
